# EUROPÄISCHE PATENTSCHRIFT

(11) **EP 1 704 627 B1**
(45) Veröffentlichungstag und Bekanntmachung des Hinweises auf die Patenterteilung: **23.01.2013**
(21) Anmeldenummer: 04820449.9
(22) Anmeldetag: 09.11.2004
(51) Int. Cl.: G01R 31/42, H02P 29/02, H02H 11/00, H02H 7/08

(54) **ANORDNUNG ZUR PRÜFUNG EINER LEISTUNGSENDSTUFE**
DEVICE FOR CONTROLLING A FINAL POWER-OUTPUT STAGE
DISPOSITIF POUR CONTROLER UN ETAGE FINAL DE PUISSANCE

(30) Priorität: 17.12.2003 DE 10359236
(43) Veröffentlichungstag der Anmeldung: 27.09.2006
(73) Patentinhaber: Continental Automotive GmbH, 30165 Hannover (DE)
(72) Erfinder: BAY, Wolfgang, 65936 Frankfurt (DE); HENNINGER, Michael, 65779 Kelkheim (DE)
(86) Internationale Anmeldenummer: PCT/EP2004/052882
(87) Internationale Veröffentlichungsnummer: WO 2005/060061

(56) Entgegenhaltungen:
- EP-A- 0 823 765
- EP-A- 1 475 875
- WO-A-94/11747
- WO-A-97/32220
- DE-A- 3 800 553
- US-A- 6 078 173

## Beschreibung

Die Erfindung betrifft eine Anordnung zur Prüfung einer Leistungsendstufe, wobei die Leistungsendstufe mindestens drei aus jeweils einer Reihenschaltung eines oberen und eines unteren Halbleiterschalters bestehende und mit Betriebsspannung beaufschlagte Halbbrücken aufweist, wobei die Verbindungspunkte der Halbleiterschalter der Halbbrücken Ausgänge bilden, welche mit Wicklungen eines mindestens dreiphasigen Motors verbunden sind, und wobei eine Steuereinrichtung vorgesehen ist, welche jeweils einen oder jeweils gleichzeitig mehrere der Halbleiterschalter nach einem vorgegebenen Programm in den leitenden Zustand schaltet und dabei prüft, ob die jeweiligen Spannungen an den Ausgängen jeweils in einem für den jeweiligen Schaltzustand vorgegebenen Toleranzbereich liegen.

Mit Halbleiterschaltern bestückte Leistungsendstufen werden unter anderem in Kraftfahrzeugen zur Ansteuerung von Verbrauchern, beispielsweise Motoren, verwendet. Durch die rasante Entwicklung von niederohmigen Leistungs-MOSFETs können auch Verbraucher im Kilowattbereich kostengünstig angesteuert werden. In Kraftfahrzeugen kann es vorkommen, dass die Leistungsendstufe und der Verbraucher räumlich voneinander getrennt angeordnet werden, wobei Kurzschlüsse der Verbraucherzuleitungen gegen Masse oder gegen Batteriespannung zu hohen Fehlerströmen führen können. Schmelzsicherungen können im Allgemeinen in diesen Stromkreisen aufgrund ihrer Toleranzen, ihrer Innenwiderstände und der hohen Nutzströme nicht eingesetzt werden. Außerdem kann infolge eines defekten MOSFETs in der Leistungsendstufe ein hoher Fehlerstrom fließen.

Aus WO 97/32220 A1 sind ein Verfahren und eine Schaltungsanordnung zur Prüfung einer Treiberschaltung für einen elektrischen Antrieb bekannt, wobei je Phase ein unterer und ein oberer Halbleiterschalter vorgesehen ist und eine Steuereinrichtung jeweils einen oder jeweils gleichzeitig mehrere der Halbleiterschalter nach einem vorgegebenen Programm in den leitenden Zustand schaltet. Dabei wird geprüft, ob an den Ausgängen, an denen ein Motor angeschlossen ist, jeweils eine Spannung in einem vorgegebenen Toleranzbereich liegt. Hierbei ist jedoch die Unterscheidbarkeit verschiedener Fehler, ob beispielsweise eine Motorwicklung einen Kurzschluss aufweist oder ein Halbleiterschalter dauernd im leitenden Zustand ist, begrenzt.

Aufgabe der Erfindung ist es daher, eine Prüfung der Leistungsendstufen vorzusehen, so dass im Falle eines Kurzschlusses die Betriebsspannung abgeschaltet bzw. gar nicht erst eingeschaltet wird, die Leistungsendstufe und das Bordnetz vor Schäden geschützt werden und eine genauere Fehlerermittlung möglich ist.

Diese Aufgabe wird bei der erfindungsgemäßen Anordnung dadurch gelöst, dass die Zuleitungen zu den Wicklungen mit Hilfe von weiteren Schaltern auftrennbar sind.

Mit dem erfindungsgemäßen Verfahren kann der Zustand der Leistungsendstufe und der angeschlossenen Leitungen und Wicklungen differenziert beurteilt werden, wobei der Motor während der Prüfung nicht oder nur unmerklich beeinflusst wird. Die Prüfung kann automatisch vor dem jeweiligen Einschalten der Leistungsendstufe erfolgen, beispielsweise bei der Betätigung des Zündschlüssels eines Kraftfahrzeugs, oder auch während des Betriebs durchgeführt werden. Durch die Trennung der Wicklungen mit Hilfe der weiteren Schalter können jeweils ein bis alle der oberen Halbleiterschalter oder ein bis alle der unteren Halbleiterschalter gleichzeitig in den leitenden Zustand gesteuert werden, so dass eine genaue Fehleranalyse möglich ist.

Eine vorteilhafte Ausgestaltung der Anordnung besteht darin, dass die Wicklungen des Motors eine Sternschaltung bilden und dass die weiteren Schalter im Sternpunkt und in den Zuleitungen von den Ausgängen zu den Wicklungen angeordnet sind. Obwohl sich für die erfindungsgemäße Anordnung auch andere steuerbare Schalter eignen, ist bei der erfindungsgemäßen Anordnung vorzugsweise vorgesehen, dass die weiteren Schalter Relais sind. Die Erfindung ist auch bei Wicklungen in Dreieckschaltung anwendbar.

Da die Betriebsspannung der Leistungsendstufen in der Regel wesentlich höher als diejenige von Mikroprozessoren oder digitalen Signalprozessoren ist, sind bei einer vorteilhaften Ausgestaltung der erfindungsgemäßen Anordnung Verbindungen der Ausgänge der Halbbrücken und der Betriebsspannung mit Eingängen von Fensterkomparatoren über Spannungsteiler vorgesehen.

Um bei abgeschalteten Halbleiterschaltern eine reproduzierbare Spannung an den Ausgängen sicherzustellen, können bei dem erfindungsgemäßen Verfahren Mittel vorgesehen sein, welche bewirken, dass bei nicht leitenden Halbleiterschaltern die jeweilige Ausgangsspannung in dem vorgegebenen mittleren Toleranzbereich liegt.

Vorzugsweise ist diese Weiterbildung derart ausgestaltet, dass die Mittel von einem Widerstand gebildet sind, der zwischen dem Ausgang einer der Halbbrücken und der Betriebsspannungsquelle liegt und zusammen mit dem Spannungsteiler am Ausgang eine Spannung im mittleren Toleranzbereich erzeugt.

Eine Prüfung ohne eine Überlastung der Leistungsendstufe und der Einrichtungen zur Spannungsversorgung ist bei einer Weiterbildung der erfindungsgemäßen Anordnung dadurch möglich, dass in der Zuleitung der Betriebsspannung ein steuerbarer Schalter vorgesehen ist, dem ein Widerstand parallel geschaltet ist, und dass der steuerbare Schalter von der Steuereinrichtung steuerbar ist. Alternativ kann bei der erfindungsgemäßen Anordnung vorgesehen sein, dass die zur Prüfung dienenden Impulse derart kurz sind, dass sowohl keine Überlastung der Halbleiterschalter stattfindet als auch der Verbraucher während der Prüfung nicht oder nur unmerklich beeinflusst wird.

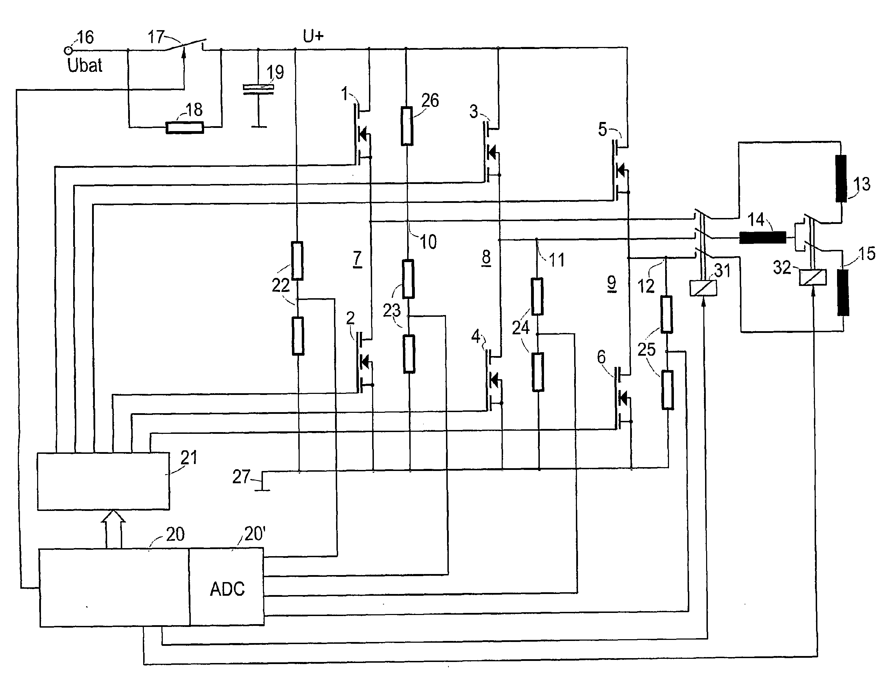

Die Erfindung lässt zahlreiche Ausführungsformen zu. Eine davon ist schematisch in der Zeichnung dargestellt und nachfolgend beschrieben.

Bei dem dargestellten Ausführungsbeispiel bilden zwei MOSFETs 1, 2; 3, 4; 5, 6 jeweils eine Halbbrücke 7, 8, 9 mit Ausgängen 10, 11, 12, an die jeweils eine der in Sternschaltung ausgeführten Wicklungen 13, 14, 15 eines Motors angeschlossen ist. In den Zuleitungen zu den Wicklungen 13, 14, 15 liegen Kontakte eines Relais 31. Außerdem kann der Sternpunkt mit Hilfe eines weiteren Relais 32 aufgetrennt werden.

Einem Eingang 16 wird die Betriebsspannung Ubat zugeführt, die als U+ über ein Relais 17 der Leistungsendstufe zugeführt wird. Parallel zu dem Relais 17 liegt ein Strombegrenzungswiderstand 18, über den ein Elektrolyt-Kondensator 19 hoher Kapazität aufgeladen werden kann, wobei das Relais erst eingeschaltet wird, wenn die Spannung U+ etwa der Spannung Ubat entspricht. Damit wird ein unzulässig hoher Ladestromstoß vermieden. Einzelheiten zu dieser bekannten Schaltung sind in DE 100 57 156 A1 ausgeführt.

Die Anordnung umfasst ferner eine Steuereinrichtung 20, die als solche im Zusammenhang mit Leistungsendstufen bekannt ist, von einem Mikrocomputer oder einem digitalen Signalprozessor gebildet wird und als solche zum Verständnis der Erfindung nicht näher erläutert zu werden braucht. Ausgänge der Steuereinrichtung 20 sind mit einer Ansteuerschaltung 21 verbunden, welche Steuersignale HS1, HS2, HS3, LS1, LS2, LS3 für die MOSFETs 1 bis 6 erzeugt. Mit der Steuereinrichtung 20 sind ferner Analog/Digital-Wandler 20' verbunden, deren Eingängen von jeweils einem Spannungsteiler 22, 23, 24, 25 erzeugte Spannungen zuführbar sind. Die Spannungsteiler weisen wesentlich höhere Widerstandswerte als die Wicklungen 13, 14, 15 auf, um den Wirkungsgrad der Endstufe im Betrieb nicht zu verschlechtern. Außerdem sind Spulen der Relais 31, 32 mit Ausgängen der Steuereinrichtung 20 verbunden.

Dem MOSFET 1 ist ein Widerstand 26 parallel geschaltet, der zusammen mit dem Spannungsteiler 23 bewirkt, dass am Ausgang 10 der Halbbrücke 7 im Falle von nicht leitenden MOSFETs 1, 2 die Hälfte der Spannung U+ anliegt.

Die Spannungsteiler 22 bis 25 sind derart ausgelegt, dass bei dem höchst möglichen Wert von U+ die zulässige Spannung von CMOS-Schaltungen nicht überschritten wird. Die vom Spannungsteiler 22 erzeugte Spannung dient für die folgenden beschriebenen einzelnen Prüfungen als Spannungsreferenz zur Bildung der Toleranzbereiche.

Bei der ersten Prüfung folgt bei zunächst offenen Kontakten des Relais 31 keine Ansteuerung der MOSFETs 1 bis 6, so dass der Ausgang 10 die Spannung U+/2 führt, was in der Steuereinrichtung 20 unter Berücksichtigung einer vorgegebenen Toleranz überprüft wird. Ist dieses der Fall, kann daraus geschlossen werden, dass in den MOSFETs 1, 2 und in der Zuleitung bis zum Relais 31 kein Kurzschluss gegen Masse 27 oder Betriebsspannung U+ vorliegt. Bei fehlerfreier Leistungsendstufe sind bei dieser ersten Prüfung auch die MOSFETs 3 bis 6 nicht leitend, so dass bei anschließend geschlossenen Kontakten des Relais 31 über die Wicklungen 13 bis 15 des Motors die Spannungen an den Ausgängen 11, 12 ebenfalls in dem mittleren Toleranzbereich liegen, was von der Steuereinrichtung 20 geprüft wird.

Bei einer anderen Prüfung werden nacheinander die "oberen" MOSFETs 1, 3, 5 in den leitenden Zustand geschaltet und dabei jeweils überprüft, ob die Ausgänge 10, 11, 12 eine Spannung annehmen, die in einem oberen Toleranzbereich, also in der Nähe der Spannung U+ liegt. Bei einer weiteren Prüfung werden die "unteren" MOSFETs 2, 4, 6 nacheinander in den leitenden Zustand gebracht. Dabei wird jeweils überprüft, ob die Spannung an den Ausgängen 10, 11, 12 im unteren Toleranzbereich, also verglichen mit U+, in der Nähe des Massepotentials liegt. Diese Prüfungen können nacheinander bei geschlossenen und geöffneten Kontakten der Relais 31, 32 vorgenommen werden.

Durch die Anordnung der Relais können für Prüfzwecke jeweils einer, zwei oder alle der oberen und der unteren Halbleiterschalter in den leitenden Zustand geschaltet und das Verhalten der Spannungen an den Ausgängen beobachtet werden. Aus der Größe der Überschreitung bzw. Unterschreitung des jeweiligen Toleranzbereichs kann auf die Art und den Ort des Defekts, beispielsweise Kurzschluss, Überlastung oder Relais-Defekten, geschlossen werden.

## Patentansprüche

1. Anordnung zur Prüfung einer Leistungsendstufe, wobei die Leistungsendstufe mindestens drei aus jeweils einer Reihenschaltung eines oberen und eines unteren Halbleiter-schalters (1,2; 3,4; 5,6) bestehende und mit Betriebsspannung beaufschlagte Halbbrücken (7, 8, 9) aufweist, wobei die Verbindungspunkte (10, 11, 12) der Halbleiterschalter der Halbbrücken Ausgänge bilden, welche mit Wicklungen (13, 14, 15) eines mindestens dreiphasigen Motors verbunden sind, und wobei eine Steuereinrichtung (20) vorgesehen ist, welche jeweils einen oder jeweils gleichzeitig mehrere der Halbleiterschalter (1 bis 6) nach einem vorgegebenen Programm in den leitenden Zustand schaltet und dabei prüft, ob die jeweiligen Spannungen an den Ausgängen (10, 11, 12) jeweils in einem für den jeweiligen Schaltzustand vorgegebenen Toleranzbereich liegen, **dadurch gekennzeichnet, dass** die Zuleitungen zu den Wicklungen (13, 14, 15) mit Hilfe von weiteren Schaltern (31, 32) auftrennbar sind.

2. Anordnung nach Anspruch 1, **dadurch gekennzeichnet , dass** die Wicklungen (13, 14, 15) des Motors eine Sternschaltung bilden und dass die weiteren Schalter (32, 31) im Sternpunkt und in den Zuleitungen von den Ausgängen zu den Wicklungen (13, 14, 15) angeordnet sind.

3. Anordnung nach einem der Ansprüche 1 oder 2, **dadurch gekennzeichnet, dass** die weiteren Schalter (31, 32) Relais sind.

4. Anordnung nach einem der vorhergehenden Ansprüche, **dadurch gekennzeichnet , dass** Verbindungen der Ausgänge (10, 11, 12) der Halbbrücken (7, 8, 9) und der Betriebsspannung mit Eingängen von Fensterkomparatoren (20') über Spannungsteiler (22, 23, 24, 25) vorgesehen sind.

5. Anordnung nach einem der vorhergehenden Ansprüche, **dadurch gekennzeichnet, dass** Mittel vorgesehen sind, welche bewirken, dass bei nicht leitenden Halbleiterschaltern (1 bis 6) die jeweilige Ausgangsspannung in dem vorgegebenen mittleren Toleranzbereich liegt.

6. Anordnung nach Anspruch 5, **dadurch gekennzeichnet , dass** die Mittel von einem Widerstand (26) gebildet sind, der zwischen dem Ausgang (10) einer der Halbbrücken (7, 8, 9) und der Betriebsspannungsquelle liegt und zusammen mit dem Spannungsteiler (23) am Ausgang (10) eine Spannung im mittleren Toleranzbereich erzeugt.

7. Anordnung nach einem der vorhergehenden Ansprüche, **dadurch gekennzeichnet, dass** in der Zuleitung der Betriebsspannung ein steuerbarer Schalter (17) vorgesehen ist, dem ein Widerstand (18) parallel geschaltet ist, und dass der steuerbare Schalter (17) von der Steuereinrichtung (20) steuerbar ist.

## Claims

1. Arrangement for testing a power output stage, the power output stage having at least three half-bridges (7, 8, 9) which each comprise a series circuit formed by an upper and a lower semiconductor switch (1, 2; 3, 4; 5, 6) and to which the operating voltage is applied, and the junction points (10, 11, 12) of the semiconductor switches of the half-bridges forming outputs which are connected to windings (13, 14, 15) of an at least three-phase motor, a control device (20) being provided, which switches respectively one or respectively simultaneously a plurality of the semiconductor switches (1 to 6) into the on state according to a predetermined program and in the process tests whether the respective voltages at the outputs (10, 11, 12) respectively lie within a predetermined tolerance range for the respective switching state, **characterized in that** the feeds to the windings (13, 14, 15) can be interrupted with the aid of further switches (31, 32).

2. Arrangement according to Claim 1, **characterized in that** the windings (13, 14, 15) of the motor form a star connection, and **in that** the further switches (32, 31) are arranged at the star point and in the feed lines, from the outputs to the windings (13, 14, 15).

3. Arrangement according to either of Claims 1 or 2, **characterized in that** the further switches (31, 32) are relays.

4. Arrangement according to one of the preceding Claims, **characterized in that** provision is made of connections of the outputs (10, 11, 12) of the half-bridges (7, 8, 9) and of the operating voltage to inputs of window comparators (20') via voltage dividers (22, 23, 24, 25).

5. Arrangement according to one of the preceding claims, **characterized in that** means are provided which have the effect that when semiconductor switches (1 to 6) are not in the on state, the respective output voltage lies within the predetermined average tolerance range.

6. Arrangement according to Claim 5, **characterized in that** the means are formed by a resistor (26), which is located between the output (10) of one of the half-bridges (7, 8, 9) and the operating voltage source and generates together with the voltage divider (23) at the output (10) a voltage in the average tolerance range.

7. Arrangement according to one of the preceding claims, **characterized in that** a controllable switch (17) is provided in the feed line of the operating voltage, a resistor (18) being connected in parallel with said controllable switch, and **in that** the controllable switch (17) can be controlled by the control device (20).

## Revendications

1. Montage de contrôle d'un étage final de puissance, l'étage de puissance ayant au moins trois demi-ponts (7, 8, 9), constitués respectivement d'un circuit série d'un commutateur (1, 3, 5) à semiconducteur supérieur et d'un commutateur (2, 4, 6) à semiconducteur inférieur et alimentés en une tension de service, les points (10, 11, 12) de liaison des commutateurs à semiconducteur des demi-ponts formant des sorties, qui sont reliées à des enroulements (13, 14, 15) d'au moins un moteur triphasé, et dans lequel il est prévu un dispositif (20) de commande, qui met respectivement un ou respectivement en même temps plusieurs des commutateurs (1 à 6) à semiconducteur suivant un programme prescrit dans l'état passant et contrôle ainsi si les tensions respectives aux sorties (10 11, 12) se trouvent respectivement dans une plage de tolérance prescrite pour l'état de commutation respectif, **caractérisé en ce que** les lignes menant aux enroulements (13, 14, 15) peuvent être coupées à l'aide d'autres commutateurs (31, 32).

2. Montage suivant la revendication 1, **caractérisé en ce que** les enroulements (13, 14, 15) forment un circuit étoile et **en ce que** les autres commutateurs (32, 31) sont montés au point neutre et dans les lignes allant des sorties aux enroulements (13, 14, 15).

3. Montage suivant la revendication 1 ou 2, **caractérisé en ce que** les autres commutateurs (31, 32) sont des relais.

4. Montage suivant l'une des revendications précédentes, **caractérisé en ce qu'**il est prévu des liaisons des sorties (10, 11, 12) des demi-ponts (7, 8, 9) et de la tension de service avec des entrées de comparateurs (20') à fenêtre par l'intermédiaire de diviseurs (22, 23, 24, 25) de tension.

5. Montage suivant l'une des revendications précédentes, **caractérisé en ce qu'**il est prévu des moyens qui font que, lorsque les commutateurs (1 à 6) à semiconducteur ne sont pas à l'état passant, la tension de sortie respective se trouve dans la plage de tolérance moyenne prescrite.

6. Montage suivant la revendication 5, **caractérisé en ce que** les moyens sont formés par une résistance (26), qui est montée entre la sortie (10) de l'un des demi-ponts (7, 8, 9) et la source de tension de service et qui, ensemble avec le diviseur (23) de tension, produit à la sortie (10) une tension dans la plage de tolérance moyenne.

7. Montage suivant l'une des revendications précédentes, **caractérisé en ce que**, dans les lignes amenant la tension de service, est prévu un interrupteur (17) qui peut être commandé et en parallèle duquel est monté une résistance (18), et **en ce que** l'interrupteur (17) qui peut être commandé peut être commandé par le dispositif (20) de commande.
